# EUROPEAN PATENT SPECIFICATION

(11) **EP 2 165 004 B1**
(45) Date of publication and mention of the grant of the patent: **13.04.2016**
(21) Application number: 08737107.6
(22) Date of filing: 28.04.2008
(51) Int. Cl.: C23C 16/26, C23C 16/54, C01B 31/02

(54) **A CONTINUOUS PROCESS FOR PREPARING AND COLLECTING NANOTUBE FILMS THAT ARE SUPPORTED BY A SUBSTRATE**
KONTINUIERLICHES VERFAHREN ZUR HERSTELLUNG UND ABNAHME VON SUBSTRATGETRÄGERTEN NANORÖHRENFILMEN
PROCESSUS CONTINU DE PRÉPARATION ET DE COLLECTE DE FILMS DE NANOTUBES QUI SONT SUPPORTÉS PAR UN SUBSTRAT

(30) Priority: 28.04.2007 GB 0708294
(43) Date of publication of application: 24.03.2010
(73) Proprietor: Q-Flo Limited, Cambridge CB2 3QZ (GB)
(72) Inventor: PICK, Martin, Yorkshire DN5 7SY (GB); FRASER, Stuart, Cambridge, CB2 3QZ (GB); WINDLE, Alan Hardwick, Cambridge CB3 0DP (GB); SCHMIDT, Ronald, Reading, RG4 5BH (GB); MOTTA, Marcelo, Durham, DH1 4BP (GB)
(74) Representative: Stuttard, Garry Philip
(86) International application number: PCT/GB2008/001461
(87) International publication number: WO 2008/132459

(56) References cited:
- WO-A-2005/007926
- WO-A-2006/099156
- MOTTA ET AL: "The parameter space for the direct spinning of fibres and films of carbon nanotubes" PHYSICA E - LOW-DIMENSIONAL SYSTEMS AND NANOSTRUCTURES, ELSEVIER SCIENCE BV, NL, vol. 37, no. 1-2, 15 March 2007 (2007-03-15), pages 40-43, XP005925431 ISSN: 1386-9477

## Description

The present invention relates to the harvesting of carbon nanotubes, preferably in the form of an aerogel grown in a high temperature Chemical Vapour Deposition (CVD) reactor. The harvesting is accomplished by depositing the nanotube aerogel continuously or discontinuously on a moving tape.

The aforementioned reactor is preferably an elongated glass tube exemplified by a tube of 90 millimetre diameter and 1.5 metre length. When in operation the reactor contains flammable gases and artefacts maintained at a high temperature. It is necessary to provide a purpose built harvesting chamber at the output end of the reactor through which the aforementioned aerogel can be withdrawn as it is produced.

The harvesting chamber provided an open-ended channel with no internal structures that allows unimpeded harvesting of carbon nanotube products which is an aerogel in the case of the present invention.

By using a combination of gas flow through the reactor and a continuously moving substrate placed close to the outlet of the aforementioned harvesting chamber at the outlet end of a furnace the continuous deposition and collection of the nanotube aerogel is made possible. The process of passing a substrate near to the outlet of the furnace allows the aerogel to be captured before it forms into a fibre. By controlling the pass speed of the substrate the width and thickness of the aerogel deposition can be altered according to need. Fibre can also be harvested by this means if required.

For the purposes of this invention an aerogel is defined as colloid that has a continuous solid phase containing dispersed gas and a colloid is defined as a mixture having particles with diameters ranging between 10⁻⁷ to 10⁻⁹.

WO-A-2005/007926 discloses the method and form of the production of an aerosol of carbon nanotubes from gas phase in a suitable reactor. Kwok et al (Dept of Mechanical Engineering, University of Connecticut): Continuous Deposition of Carbon Nanotubes Under open Air Conditions on a Moving Fused Quartz Substrate Using Pyrolytic CVD. Journal: Carbon 2005 Vol. 43 No. 12 pp 2571-2578 does not conflict with the present invention as the nanotubes are not in an aerogel form and are caused to settle on the substrate using a vacuum which draws reaction gas through the substrate. WO-A-2006/099156 does not conflict with the present invention as the nanotubes are not in aerogel form.

The process for preparing the carbon nanotubes is derived from WO-A-2005/007926 which discloses a process for preparing continuous fibers of carbon nanotubes from the gas phase using a chemical vapor deposition (CVD) process. Briefly this involves injecting an appropriate reaction mixture into a reactor tube that is maintained at a temperature of at least 1100°C using a carrier gas to drive the reaction mixture through the reactor tube. In addition to the carrier gas, the reaction mixture consists of a hydrocarbon feedstock, a soluble or volatile metal-containing catalyst precursor and a sulphur-containing species that behaves as a growth promoter. The nanotubes are produced as an aerogel.

Thus viewed from one aspect the present invention provides a process for depositing an aerogel of carbon nanotubes directly on a substrate which is passed across the outlet of a reactor in which the carbon nanotube aerogel is prepared characterised in that the substrate is a tape having on one side an adhesive material to retain carbon nanotubes.

The present invention uses a substrate which is in the form of a tape which can be impervious or porous. The tape may be contained on a spool and is unwound, passes near the outlet of the aforementioned furnace and is rewound on a take-up reel. The tape captures the nanotubes produced as described above mechanically drawing the aerogel from the reactor. The tape and its captured nanotubes are wound onto a suitable spool and can be unwound when needed.

According to the present invention the reactor may consist of a ceramic tube which (for example) can be 1.5 metres long and 90 mm in diameter. In the preferred example of use the reactor is heated to 1180°C using a tube furnace. The top of the mullite tube is equipped with appropriate stainless steel fittings that allow the simultaneous injection of a carrier gas while excluding the ambient atmosphere from the reaction zone. The bottom of the reactor tube is equipped with a "Gas-exchange valve" as described in WO-A-2006//01001.

The aerogel of CNTs is collected onto the adhesive side of tape exemplified by Scotch(R) *"Magic Tape*" and Scotch(R) *"Crystal Clear Tape".* Each of these may be used as the substrate as-prepared by the 3M Corporation.

### EXAMPLE

An example of a solution was prepared that contained 1.8% (wt/wt) ferrocene, 0.4 % (wt/wt) thiophene and 97.8% (wt/wt) absolute ethanol (>99.9% ethanol). The mixture was filtered through a 25 micron syringe filter to remove non-dissolved particles of ferrocene. The filtered reaction mixture was de-gassed by placing it in a bottle under vacuum and immersing the bottle in an ultrasonic bath.

The reaction tube is first purged with argon to remove the air and then with hydrogen at a flow rate of 2 L/min for at least 10 minutes prior to beginning the reaction. While maintaining a fixed hydrogen injection rate through the top of the furnace (either 1.5 L/min or 2.25 L/min as noted below), the reaction mixture is injected into the top of the furnace at a rate of 0.1 ml/minute using a high pressure, liquid chromatography (HPLC) pump.

The reaction can be monitored visually through the use of a mirror to look through the gas-valve and up into the reaction zone. After injecting the reaction mixture for several minutes, the aerogel will appear as a dark cloud which is generally cylindrical in shape. The aerogel cylinder (referred to as a sock) is extracted through the gas-exchange valve from the reaction zone using a long, stainless steel rod.

The aerogel is deposited onto the adhesive side of the tape, nearest to the top of a collection reel. Initially the take-up reel is at rest. The wind-up of the tape begins as the take-up reel is slowly accelerated using its motor drive. The aerogel is monitored as it leaves the bottom of the gas valve, and the wind-up motor is accelerated until the width of the aerogel decreases due to its elongation. The winding rate of the take-up reel can be decreased until it reaches a rate such that the aerogel maintains a constant and stable width that spans the desired width of the tape (typically between 1 to 2 cm). When this occurs the windup is maintained at a constant rate until the supply of tape is exhausted. Adhesion to tape not provided with an adhesive can be provided by electrostatic, magnetic or other means or if required.

Samples are prepared for electrical sheet resistance measurements by masking a well-defined region with a glass slide and coating the exposing areas of the film with a thin layer (approximately 50 nm) of gold by sputtering. The resistance across the gold electrodes is determined using a Fluke 27 Multimeter.

The transparency of the films is determined with a Uvikon 860 double-beam spectrophotometer (Kontron Instruments) at a fixed wavelength of 550 nm using the corresponding tape substrate (without CNTs present) as a reference.

Using a hydrogen flow rate of 1.5 L/min during injection and Scotch(R) "Magic Tape" as a substrate, samples were obtained that transmitted 94% visible light at 550 nm and exhibited a DC sheet resistance of 2.59 kiloOhms/square.

A sample prepared using a hydrogen flow rate of 2.5L/min and Scotch Crystal Clear Tape exhibited a DC resistance of 40 KiloOhms/square and transmitted 97% light at 550 nm.

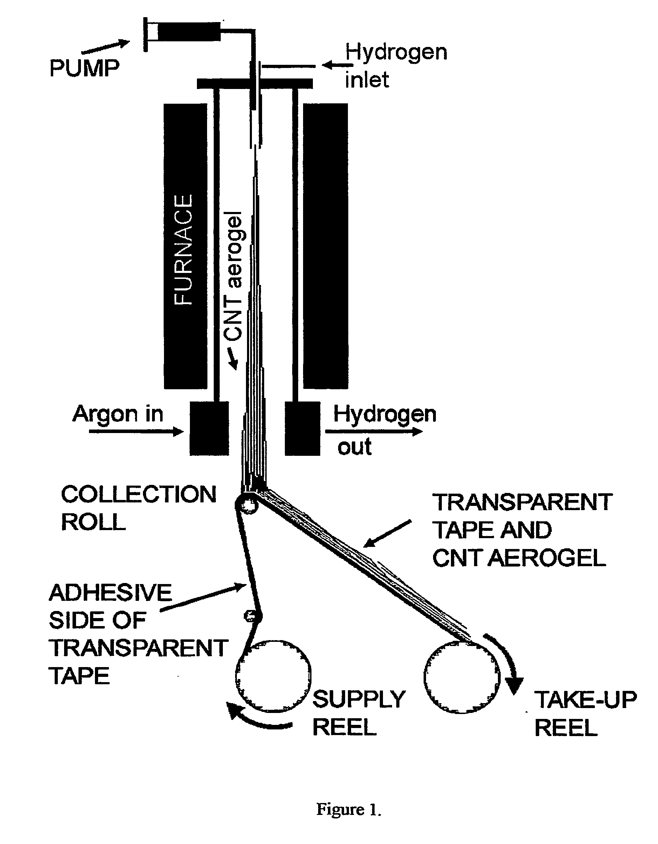

A detailed description will be made with reference to Fig. 1 which shows schematically the HPLC pump which injects the feedstock into the reaction vessel via the hydrogen inlet. The reaction vessel is heated by the furnace as shown. Argon in/hydrogen out indicates the operation of the gas isolation/exchange valve. The aerogel sock is indicated within the reaction vessel. The aerogel sock is shown being taken up by the travelling tape on its adhesive side. Driven take up reel and passive supply reel are shown.

It is understood that the description with reference to Fig. 1 is for example only.

The principle motivation for this invention is the provision of transparent conductors that can be used as anti-static packaging materials, as shielding against electromagnetic interference (EMT), as transparent electrodes in electronic devices and any application to which the properties of aerogel/tape substrate can be applied. Examples of such applications are electro-optical cells for the generation of electricity from sunlight, liquid crystal displays, plasma displays, touch-sensitive displays and electroluminescent displays. In any embodiment of the invention, the preferred form of the substrate is a transparent polymer.

In other embodiments of this invention, optical transparency may be a less important property. For example, the invention may be used to impart electrical conductivity to tapes that are initially electrically insulating or the carbon nanotube layer deposited onto the tape may be used to provide mechanical reinforcement. These embodiments may also use a polymer substrate (which may or may not be transparent) but other suitable substrates include paper, cloth, ceramic, metal ribbons and composite materials.

## Claims

1. A process for depositing an aerogel of carbon nanotubes directly on a substrate which is passed across the outlet of a reactor in which the carbon nanotube aerogel is prepared **characterised in that** the substrate is a tape having on one side an adhesive material to retain carbon nanotubes.

2. A process according to claim 1 wherein the substrate is passed continuously across the outlet of the reactor in which the carbon nanotube aerogel is prepared.

3. A process as claimed in claims 1 or 2 in which the coated substrate is transparent to electromagnetic radiation.

4. A process as claimed in claims 1 to 3 in which the coated substrate is transparent to specific wavelengths of electromagnetic radiation.

5. A process as claimed in claims 1 or 2 in which the coated substrate is opaque to electromagnetic radiation.

6. A process as claimed in claims 1 or 2 in which the electrical properties of the substrate are modified when coated with carbon nanotubes.

7. A process as claimed in claims 1 or 2 in which the thermal properties of the substrate are modified.

8. A process as claimed in claims 1 or 2 in which the mechanical properties of the substrate are modified.

9. A process as claimed in claims 6 to 8 wherein a combination of two or more of the electrical, thermal or mechanical properties of the substrate are modified.

## Patentansprüche

1. Verfahren zum direkten Abscheiden eines Aerogels von Kohlenstoff-Nanoröhren auf ein Substrat, welches an einer Auslassöffnung eines Reaktors vorbeigeführt wird, in welchem das Kohlenstoff-Nanoröhren-Aerogel hergestellt wird, **dadurch gekennzeichnet, dass** das Substrat ein Band ist, welches auf einer Seite ein Klebematerial aufweist, um Kohlenstoff-Nanoröhren festzuhalten.

2. Verfahren gemäß Anspruch 1, wobei das Substrat kontinuierlich an der Auslassöffnung des Reaktors vorbeigeführt wird, in welchem das Kohlenstoff-Nanoröhren-Aerogel zubereitet wird.

3. Verfahren wie beansprucht in Ansprüchen 1 oder 2, in welchem das beschichtete Substrat für elektromagnetische Strahlung durchlässig ist.

4. Verfahren wie beansprucht in Ansprüchen 1 bis 3, in welchem das beschichtete Substrat für bestimmte Wellenlängen einer elektromagnetischen Strahlung durchlässig ist.

5. Verfahren wie beansprucht in Ansprüchen 1 oder 2, in welchem das beschichtete Substrat für elektromagnetische Strahlung undurchlässig ist.

6. Verfahren wie beansprucht in Ansprüchen 1 oder 2, in welchem die elektrischen Eigenschaften des Substrats bei Beschichtung mit Kohlenstoff-Nanoröhren modifiziert werden.

7. Verfahren wie beansprucht in Ansprüchen 1 oder 2, in welchem die thermischen Eigenschaften des Substrats modifiziert werden.

8. Verfahren wie beansprucht in Ansprüchen 1 oder 2, in welchem die mechanischen Eigenschaften des Substrats modifiziert werden.

9. Verfahren wie beansprucht in Ansprüchen 6 bis 8, wobei eine Kombination von zwei oder mehreren der elektrischen, thermischen oder mechanischen Eigenschaften des Substrats modifiziert werden.

## Revendications

1. Procédé de dépôt d'un aérogel de nanotubes de carbone directement sur un substrat qui est amené à passer à travers la sortie d'un réacteur dans lequel l'aérogel de nanotubes de carbone est préparé, **caractérisé en ce que** le substrat est un ruban ayant sur un côté un matériau adhésif pour retenir des nanotubes de carbone.

2. Procédé selon la revendication 1, dans lequel le substrat est amené à passer en continu à travers la sortie du réacteur dans lequel l'aérogel de nanotubes de carbone est préparé.

3. Procédé tel que revendiqué dans la revendication 1 ou 2, dans lequel le substrat revêtu est transparent au rayonnement électromagnétique.

4. Procédé tel que revendiqué dans les revendications 1 à 3, dans lequel le substrat revêtu est transparent à des longueurs d'onde spécifiques de rayonnement électromagnétique.

5. Procédé tel que revendiqué dans la revendication 1 ou 2, dans lequel le substrat revêtu est opaque au rayonnement électromagnétique.

6. Procédé tel que revendiqué dans la revendication 1 ou 2, dans lequel les propriétés électriques du substrat sont modifiées lorsqu'il est revêtu de nanotubes de carbone.

7. Procédé tel que revendiqué dans la revendication 1 ou 2, dans lequel les propriétés thermiques du substrat sont modifiées.

8. Procédé tel que revendiqué dans la revendication 1 ou 2, dans lequel les propriétés mécaniques du substrat sont modifiées.

9. Procédé tel que revendiqué dans les revendications 6 à 8, dans lequel une combinaison d'au moins deux des propriétés électriques, thermiques ou mécaniques du substrat est modifiée.
